# EUROPÄISCHE PATENTANMELDUNG

(11) **EP 4 665 097 A1**
(43) Veröffentlichungstag der Anmeldung: **17.12.2025**
(21) Anmeldenummer: 24181893.9
(22) Anmeldetag: 13.06.2024
(51) Int. Cl.: H05K 7/20, B60K 11/02

(54) **ANORDNUNG UND VERFAHREN ZUR KÜHLUNG EINER VORRICHTUNG, INSBESONDERE ELEKTRISCHEN VORRICHTUNG, WIE BEISPIELSWEISE EINEN, VORZUGSWEISE FÜR DEN EINSATZ IM INDUSTRIELLEN UMFELD BETRIEBENEN, UMRICHTER**

(71) Anmelder: Siemens Aktiengesellschaft, 80333 München (DE)
(72) Erfinder: Danov, Vladimir, 91056 Erlangen (DE); Fleisch, Karl, 91054 Erlangen (DE); Müller, Volker, 90459 Nürnberg (DE); Wohlfart, Manfred, 91369 Wiesenthau (DE)
(74) Vertreter: Siemens Patent Attorneys

(57) **Zusammenfassung**

Die Erfindung betrifft eine Anordnung zur Kühlung einer Vorrichtung, insbesondere elektrischen Vorrichtung, wie beispielsweise einen, vorzugsweise für den Einsatz im industriellen Umfeld betriebenen, Umrichter, aufweisend zumindest einen, insbesondere als Rohr ausgebildeten, ersten Hohlkörper zur Aufnahme einer Kühlflüssigkeit der Kühlungsanordnung, die derart ausgestaltet ist, dass auf dem höchsten Punkt des ersten Hohlkörpers ein zweiter Hohlkörper derart ausgeformt und mit dem ersten Hohlkörper derart verbunden ist, dass beim Befüllen des ersten Hohlkörpers mit der Kühlflüssigkeit, zumindest ein Teil des zweiten Hohlkörpers ein Gas, insbesondere Raumluft, derart einschließt, dass nach dem Befüllen das Gas in der Anordnung zur Kühlung, vorzugsweise im zweiten Hohlkörper, erhalten bleibt, wobei Gas und Kühlmittel zumindest nach dem Befüllen derart mechanisch aufeinander einwirken können, dass eine Ausdehnung der Kühlflüssigkeit das im zweiten Hohlkörper konservierte Gas komprimieren kann. Ferner betrifft die Erfindung ein entsprechendes Verfahren.

## Beschreibung

Die Erfindung betrifft eine Anordnung zur Kühlung einer Vorrichtung, insbesondere elektrischen Vorrichtung, wie beispielsweise einen, vorzugsweise für den Einsatz im industriellen Umfeld betriebenen, Umrichter gemäß dem Oberbegriff des Anspruchs 1 sowie ein Verfahren zur Kühlung einer Vorrichtung, insbesondere elektrischen Vorrichtung, wie beispielsweise einen, vorzugsweise für den Einsatz im industriellen Umfeld betriebenen, Umrichter gemäß dem Oberbegriff des Anspruchs 14.

Es ist bekannt, dass große Umrichter, also Hochleistungsumrichter, wie sie für den Einsatz in Anwendungen mit hohen Leistungsanforderungen, wie beispielsweise in der Hochspannungsübertragung, der Industrie oder in erneuerbaren Energiesystemen verwendet werden, einer Kühlung bedürfen. Gegenwärtig erfolgt dies in der Regel wassergekühlt. Dabei wird der Umrichter in der Regel mit Wasseranschlüssen ausgestattet und an den Kunden geliefert, um dann an einen kundenseitig bereitgestellten Kühlwasserkreislauf angeschlossen zu werden.

In den Betriebsanweisungen der Umrichter sind in der Regel seitens des Herstellers Anforderungen an den Kühlkreislauf beschrieben, die vom Kunden für einen sicheren Betrieb einzuhalten sind. Werden solche Anforderungen nicht vorgegeben oder weicht der Anschluss im Einsatz beim Kunden aus anderen Gründen von einer sicheren Kühlung ab, beispielsweise weil die Kühlung vor Ort ungeeignete Betriebsparameter, -eigenschaften für den Anschluss oder sogar Mängel aufweist, besteht die Gefahr von Sachschäden, die hersteller- und/oder kundenseitig zu Folgeproblemen, wie Ausfällen, Reparaturaufwand und damit einhergehenden finanziellen Schäden.

Die der Erfindung zugrunde liegende Aufgabe besteht daher darin, Probleme beim kundenseitigen Ansatz, insbesondere Anschluss an der Kühlung, zu erkennen. Ferner besteht die Aufgabe darin eine Lösung anzugeben, die zumindest Teile der erkannten Probleme überwindet.

Diese Aufgabe wird durch die Anordnung zur Kühlung einer Vorrichtung, insbesondere elektrischen Vorrichtung, wie beispielsweise einen, vorzugsweise für den Einsatz im industriellen Umfeld betriebenen, Umrichter gemäß dem Oberbegriff des Anspruchs 1 durch dessen kennzeichnende Merkmale sowie durch das Verfahren zur Kühlung einer Vorrichtung, insbesondere elektrischen Vorrichtung, wie beispielsweise einen, vorzugsweise für den Einsatz im industriellen Umfeld betriebenen, Umrichter gemäß dem Oberbegriff des Anspruchs 14, durch dessen kennzeichnende Merkmale gelöst.

Bei der erfindungsgemäßen Anordnung zur Kühlung einer Vorrichtung, insbesondere elektrischen Vorrichtung, wie beispielsweise einen, vorzugsweise für den Einsatz im industriellen Umfeld betriebenen, Umrichter, aufweisend zumindest einen, insbesondere als Rohr ausgebildeten, ersten Hohlkörper zur Aufnahme einer Kühlflüssigkeit der Kühlungsanordnung, ist auf dem höchsten Punkt des ersten Hohlkörpers ein zweiter Hohlkörper derart ausgeformt und mit dem ersten Hohlkörper derart verbunden, dass beim Befüllen des ersten Hohlkörpers mit der Kühlflüssigkeit zumindest ein Teil des zweiten Hohlkörpers ein Gas, insbesondere Raumluft, derart einschließt, dass nach dem Befüllen das Gas in der Anordnung zur Kühlung, vorzugsweise im zweiten Hohlkörper, erhalten bleibt, wobei Gas und Kühlmittel zumindest nach dem Befüllen derart mechanisch aufeinander einwirken können, dass eine Ausdehnung der Kühlflüssigkeit das im zweiten Hohlkörper konservierte Gas komprimieren kann.

Hiermit wird das erfinderseitig erkannte Problem adressiert, dass Leckagen aufgrund Druckpulsation im Kühlkreislauf entstehen können, die beispielsweise durch falsch dimensionierte oder kundenseitig falsch gesteuerte Pumpen im Kreislauf, falsch dimensionierte und gesteuerte Ventile oder beschädigte Pumpen und Ventile auftreten. Um diesem Problem nun zu begegnen, wird seitens der erfindungsgemäßen Anordnung Gas, das sich im zweiten Hohlkörper aufhält, beim Befüllen durch das Kühlmittel auch weiter dort erhalten, so dass nach dem Befüllen das Gas bei auftretenden Druckpulsationen komprimiert werden kann, so dass wie durch Tests belegt, der Verlauf der Druckpulsationen, insbesondere Pulsmaxima und Dauer des Druckaufbaus und -abbaus, deutlich weniger Kraft auf das Kühlsystem und somit auch auf alle etwaigen Schwachstellen des Systems ausübt. Eine besonders einfache Lösung ist gegeben, wenn es sich bei dem Gas um eingeschlossene Luft handelt. Hierdurch bedarf es keiner separaten Befüllung eines Gases oder Gasgemisches. Ein anderes Gas oder Gasgemisch wäre denkbar, wenn dadurch die Kompensation von Druckpulsationen verbessert werden würden und/oder andere Eigenschaften im Betrieb dies bedingen.

Beim erfindungsgemäßen Verfahren zur Kühlung einer Vorrichtung, insbesondere elektrischen Vorrichtung, wie einem beispielsweise, vorzugsweise für den Einsatz im industriellen Umfeld betriebenen, Umrichter, mit zumindest einem, insbesondere als Rohr ausgebildeten, ersten Hohlkörper zur Aufnahme einer Kühlflüssigkeit der Kühlungsanordnung, wird auf dem höchsten Punkt des ersten Hohlkörpers ein zweiter Hohlkörper derart ausgeformt und mit dem ersten Hohlkörper derart funktional verbunden und betrieben, dass beim Befüllen des ersten Hohlkörpers mit der Kühlflüssigkeit, zumindest ein Teil des zweiten Hohlkörpers, ein Gas, insbesondere Raumluft, derart eingeschlossen wird, dass nach dem Befüllen das Gas in der Anordnung zur Kühlung, vorzugsweise im zweiten Hohlkörper, erhalten bleibt, wobei Gas und Kühlmittel zumindest nach dem Befüllen derart mechanisch aufeinander einwirken können, dass eine Ausdehnung der Kühlflüssigkeit das im zweiten Hohlkörper konservierte Gas komprimieren kann.

Das erfindungsgemäße Verfahren lehrt die erfindungsgemäßen Schritte, die die erfindungsgemäße Anordnung verwirklicht. Damit realisiert es mutatis mutandis die gleichen Vorteile wie die erfindungsgemäße Anordnung.

Weitere vorteilhafte Ausgestaltungen und Weiterbildungen der Erfindung sind durch die Unteransprüche angegeben.

Die im Folgenden genannten Vorteile müssen nicht notwendigerweise durch die Gegenstände der unabhängigen Patentansprüche erzielt werden. Vielmehr kann es sich hierbei auch um Vorteile handeln, welche lediglich durch einzelne Ausführungsformen, Varianten oder Weiterbildungen erzielt werden. Gleiches gilt für die nachfolgenden Erläuterungen.

Wird die erfindungsgemäße Anordnung derart weitergebildet, dass die Verbindung zwischen erstem Hohlkörper und zweitem Hohlkörper derart ausgestaltet ist, dass das Gas durch eine zumindest temporär, insbesondere während des Befüllens, verschlossene Trennvorrichtung von der Kühlflüssigkeit getrennt ist, so kann durch die Trennvorrichtung steuernd auf die Konservierung Einfluss genommen werden. Beispielsweise kann dies von Vorteil sein, um zu vermeiden, dass Teile des Gases beim Befüllen sich mit der Kühlflüssigkeit vermischen und/oder weggespült werden. Hierzu kann vor dem Befüllen die Trennvorrichtung geschlossen und nach Abschluss des Befüllens wieder geöffnet werden. Die Trennvorrichtung ist auch besonders geeignet, wenn es sich bei dem Gas nicht um Luft handelt, da das Gas bei geschlossener Trennvorrichtung in den zweiten Hohlkörper gefüllt werden kann, wobei dies insbesondere durch einen separaten Einlass in den zweiten Hohlkörper erfolgen könnte, so dass nach dem Befüllen, wenn die Kühlflüssigkeit die Luft aus dem Kühlkreislauf geschwemmt hat, die Trennvorrichtung geöffnet wird, so dass die Kühlflüssigkeit das Gas bei auftretenden Druckpulsationen komprimieren kann. Die Trennvorrichtung kann auch dazu dienen die Kühlflüssigkeit dauerhaft vor direktem Kontakt mit dem Gas zu bewahren, wobei zumindest Teile der Trennvorrichtung dann erfindungsgemäß derart weitergebildet werden, dass sie die mechanische Kraft der Druckpulsation auf das Gas übertragen.

Alternativ oder ergänzend kann die erfindungsgemäße Anordnung derart weitergebildet werden, dass die Trennvorrichtung derart ausgestaltet ist, dass sie manuell und/oder motorgetrieben, insbesondere prozessorgesteuert, verschließbar ist, dies ist dann von Vorteil, wenn die Trennung nur temporär, insbesondere während des Befüllens, vollzogen werden soll.

Um eine Weitergabe der Kraft der Druckpulsation auf das Gas zu gewährleisten, während dieses dauerhaft von der Kühlflüssigkeit getrennt ist, ist die Weiterbildung der erfindungsgemäßen Anordnung derart, dass die Trennvorrichtung derart ausgestaltet ist, dass sie dauerhaft verschlossen ist, wobei die Trennvorrichtung zumindest teilweise als flexible Membran ausgestaltet ist, besonders geeignet.

Besonders einfach und damit auch kostengünstig, aber auch aufgrund geringerer mechanischer Teile weniger verschleiß- und/oder fehleranfällig ist die Weiterbildung der erfindungsgemäßen Anordnung, bei der die Verbindung zwischen erstem Hohlkörper und zweitem Hohlkörper derart ausgestaltet ist, dass zumindest ein Teil des zweiten Hohlkörpers für die Kühlflüssigkeit derart durchlässig ist, dass die Kühlflüssigkeit jederzeit unmittelbaren Kontakt zum eingeschlossenen Gas hat. Hierdurch wird ausgenutzt, dass Gas und Kühlflüssigkeit aufgrund ihrer unterschiedlichen Dichten von selbst getrennt bleiben.

Besonders gut funktioniert dies, wenn die erfindungsgemäße Anordnung derart weitergebildet wird, dass der zweite Hohlkörper am ersten Hohlkörper derart ausgeformt ist, dass zumindest Teile des zweiten Hohlkörpers ab dem Befüllen und während des Betriebs der Kühlung über dem höchsten Niveau des Kühlmittels in der Kühlungsanordnung dauerhaft zu liegen kommen, damit läuft gewissermaßen beim Befüllen das Kühlmittel unter dem Gas durch. Ein weiterer Vorteil ist, dass sich in der Kühlflüssigkeit befindende Lufteinschlüsse, insbesondere wenn das Gas ein Luft oder Luft/Gasgemisch ist, teilweise in den zweiten Hohlkörper entweichen werden. Etwaige, beispielsweise durch Verwirbelungen oder andere physikalische Kräfte verursachte, Mitnahme von Luft aus dem zweiten Hohlkörper kann dadurch teilweise ausgeglichen werden. Denkbar sind auch Weiterbildungen des zweiten Hohlkörpers und/oder der Anschlussstelle des zweiten Hohlkörpers am ersten Hohlkörper, die, insbesondere bezüglich der Verwirbelung, optimiert sind.

Ein einfacher, dichter und bzgl. Festigkeit geeigneter Verbund von erstem und zweitem Hohlkörper ist gegeben, wenn die erfindungsgemäße Anordnung derart weitergebildet ist, dass die Verbindung zwischen zweitem Hohlkörper und erstem Hohlkörper derart ausgestaltet ist, dass der zweite Hohlkörper mit dem ersten Hohlkörper zumindest teilweise durch Verschweißungen verbunden ist.

Alternativ oder ergänzend kann die erfindungsgemäße Anordnung auch derart weitergebildet werden, dass die Verbindung zwischen zweitem Holkörper und erstem Hohlkörper derart ausgestaltet ist, dass erster Hohlkörper und zweiter Hohlkörper eine, insbesondere durch ein Gießverfahren erzeugte, Einheit bilden. Ein aus einem Guss gefertigter Verbund kann unter Umständen kostengünstiger, aber auch stabiler und dichter sein. Wenn zumindest Teile des ersten und/oder zweiten Hohlkörpers an der Durchgangsstelle derart ausgeformt sind, dann können auch strömungsoptimierte Formen dadurch erzeugt werden und der Anschluss des zweiten Hohlkörpers etwas abgesetzt von der Kühlflüssigkeit erfolgen. Dies kann beispielsweise durch Anschweißen oder alternativ oder ergänzend auch durch die Weiterbildung bewirkt werden, gemäß der die erfindungsgemäße Anordnung derart ausgebildet ist, dass die Verbindung zwischen zweitem Holkörper und erstem Hohlkörper derart ausgestaltet ist, dass der zweite Hohlkörper durch Schrauben am ersten Hohlkörper befestigt wird. Diese Verschraubung kann durch separate einzelne Schrauben erfolgen und/oder zumindest Teile des zweiten Hohlkörpers können Gewinde und Gegengewinde aufweisen, so dass ganze Teile angeschraubt werden.

Dies wird insbesondere dann vorteilhaft durchgeführt werden können, wenn die erfindungsgemäße Anordnung derart weitergebildet wird, dass der zweite Hohlkörper als eine aus zumindest einem rohrförmigen Teil gebildete Anordnung ausgestaltet ist.

Alternativ oder ergänzend wird die erfindungsgemäße Anordnung derart weitergebildet, dass der zweite Hohlkörper als Rohr ausgestaltet ist, wobei das derart ausgeformt und mit dem ersten Hohlkörper verbunden ist, dass zumindest ein Rohrende des Rohres mit dem zweiten Hohlkörper für die Kühlflüssigkeit durchlässig verbunden ist und aus dem ersten Hohlkörper heraustritt. Rohre sind Massenware und daher kostengünstig verwendbar, auch etwaige Anschlüsse, Gewinde und Gegenstücke sind entsprechend vorhanden, so dass diese Variante eine sehr kostengünstige Lösung darstellt. Dabei ist bei lediglich einem Anschluss an einer Seite des Rohres für die zweite Rohröffnung gemäß einer weiteren Weiterbildung ein Abschluss, beispielsweise ein anschraubbares Endstück, eine Kappe oder Vergleichbares, das das Gas vor einem Austritt bewahrt, vorgesehen, wie gemäß der Weiterbildung, wonach die erfindungsgemäße Anordnung derart weitergebildet wird, dass das zweite Rohrende des Rohres und/oder rohrförmigen Teils verschlossen ist, vorgesehen.

Alternativ kann die erfindungsgemäße Anordnung derart weitergebildet werden, dass das rohrförmige Teil seitlich in den ersten Hohlkörper wieder eintritt und durchlässig mit ihm verbunden ist. Hierdurch wird gewissermaßen eine zumindest teilweise parallel zum ersten Hohlkörper ausgeformte Struktur des zweiten Hohlkörpers möglich, deren Volumen durch entsprechende Formung des Rohres/der rohrförmigen Teile dann auf ein Maß vergrößert werden kann, dass man mehr Gas konservieren kann, so dass mehr Kompressionsenergie aufgenommen werden kann, beispielsweise könnte durch einen mäanderförmigen Verlauf entlang des ersten Hohlkörpers mehr Volumen auf der gleichen Strecke bewirkt werden als bei einer geraden Führung des Rohres bis zur Eintrittsöffnung.

Eine einfache und kostengünstige Weiterbildung der erfindungsgemäßen Anordnung ist gegeben, wenn der zweite Hohlkörper aus einem Rohrstück sowie einem ersten und einem zweiten, jeweils an einem Ende des Rohrstücks befestigten, Winkelstück gebildet ist, wobei jeweils das freie Ende des Winkelstücks mit dem ersten Hohlkörper für die Kühlflüssigkeit durchlässig verbunden ist und wobei das Rohrstück parallel zum ersten Hohlkörper verläuft. Diese Bauformen sind Massenware und können eine Art Bypass zum ersten Hohlkörper bilden, der für die meisten Anwendungen ausreichen kann.

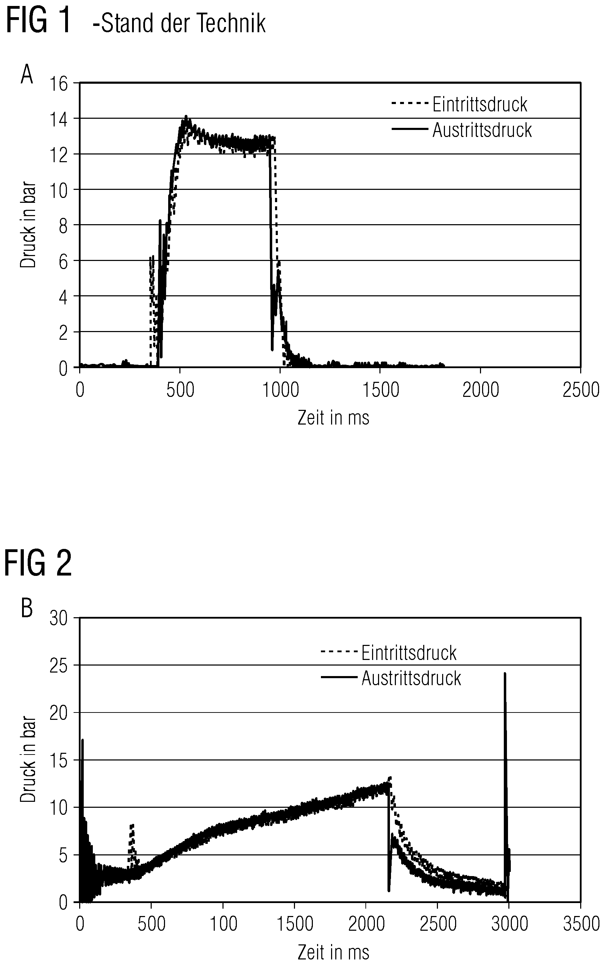

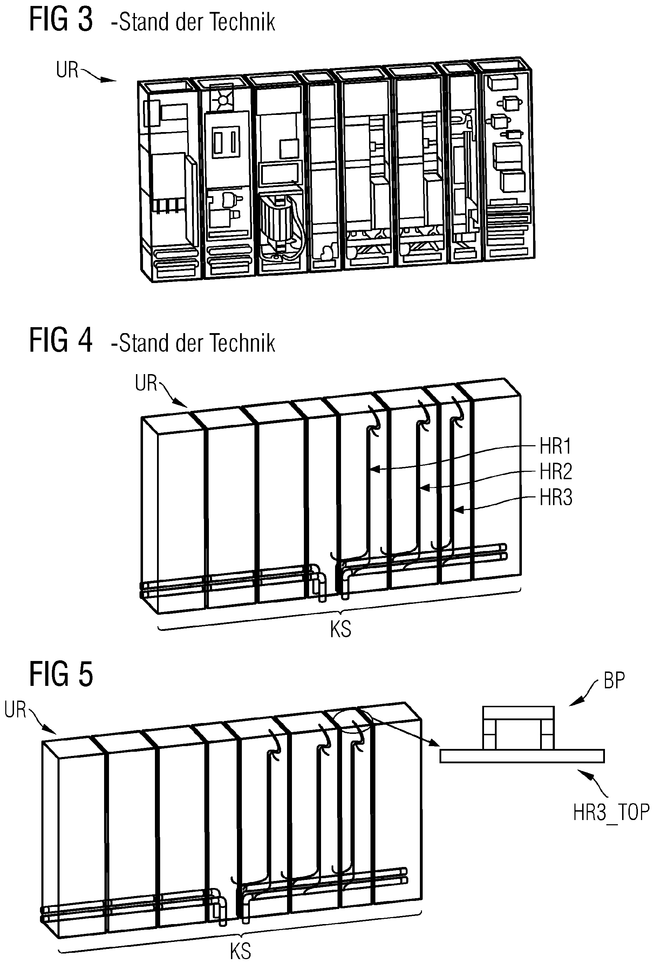

Im Folgenden wird ausgehend von einem in Figur 1 gezeigten Ergebnis aus einem in einem System gemäß Stand der Technik per Simulation durchgeführten Druckpulsationstest, welcher das erfindungsgemäße Auffinden des Problems nachzeichnet, und ausgehend von einem in Figur 3 gezeigten Umrichter und dessen in Figur 4 gezeigten Kühlung Ausführungsbeispiele der Erfindung anhand der Figuren 2 und 5 näher erläutert. In den Figuren 1 bis 5 sind gleiche oder funktionsgleiche Elemente mit denselben Bezugszeichen versehen, sofern nichts anderes angegeben ist. Es zeigen:
- Figur 1: einen mittels für eine Kühlkreislaufsimulation geeigneten Test erzeugten Verlauf eines Druckpulses wie er in einem Kühlkreislaufsystem gemäß Stand der Technik auftreten kann,
- Figur 2: einen mittels für eine Kühlkreislaufsimulation geeigneten Test erzeugten Verlauf eines Druckpulses wie er in einem die erfindungsgemäße Wirkweise verwirklichenden Kühlkreislaufsystem auftreten kann,
- Figur 3: schematisch einen Umrichter gemäß Stand der Technik,
- Figur 4: schematisch den Aufbau eines für den Umrichter vorgesehenen Kühlsystems gemäß dem Stand der Technik.
- Figur 5: schematisch ein Ausführungsbeispiel der erfindungsgemäßen Vorrichtung, welche einem Ausführungsbeispiel des erfindungsgemäßen Verfahrens folgend das Kühlsystem vor den Auswirkungen von Druckpulsen schützt.

Bei den im Folgenden in den Figuren 1 bis 5 ausgehend vom Stand der Technik erläuterten Ausführungsbeispielen handelt es sich um bevorzugte Ausführungsformen und Weiterbildungen der Erfindung.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis der unabhängigen Ansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

Gleiche Bezugszeichen haben in den verschiedenen Figuren die gleiche Bedeutung.

Die Figur 1 zeigt in einem ersten Diagramm A einen mittels für eine Kühlkreislaufsimulation geeigneten Test erzeugten Verlauf eines Druckpulses wie er in einem Kühlkreislaufsystem gemäß Stand der Technik auftreten kann.

Dieser Test ist Ausfluss der erfinderischen Überlegung, dass beispielsweise durch falsch dimensionierte oder falsch gesteuerte Pumpen im Kühlkreislauf des Kunden bzw. beispielsweise falsch dimensionierte oder falsch gesteuerte Ventile sowie durch beschädigte Pumpen und Ventile Druckpulsationen auftreten können und zu so genannten "Leckagen", also Schäden im Kühlsystem, führen können, denn wie das Diagramm zeigt, steigt der Druck für eine kurze Zeit auf einen - durch die Simulation begrenzten - Maximaldruck, so dass nachweislich für einen Druckpuls hohe Energien auf das Kühlsystem wirken.

Durch die erfinderischen Überlegungen wurden Druckpulsationen als ein Problem erkannt, dass herstellerseitig mindestens abgeschwächt, im Idealfall vollständig ausgeschlossen werden kann.

Hierzu wurden gemäß weiteren erfinderischen Überlegungen zur Lösung des Problems eine Überdimensionierung des Systems in Betracht gezogen, wie sie gemäß Stand der Technik für Teile zum Schutz vor Überlasten gelegentlich eingesetzt wird, bei der beispielsweise alle am Kühlkreislauf mitwirkenden Teile, wie beispielsweise Rohre, Schläuche, Wärmetauscher, Verbindungen etc., für einen wesentlich höheren Druck ausgelegt werden als ein zu erwartender Druck im Betrieb. Dadurch können diese Systeme die Druckpulsationen aushalten. Allerdings ist diese Lösung insofern nachteilig, da man dadurch teurere Komponenten mit höheren Wanddicken einsetzen muss, die zusätzlich das Gewicht des Umrichters negativ beeinflussen.

Auch wurde eine Drucküberwachung in Betracht gezogen, bei der im Gerät, also dem Umrichter und/oder Kühlkreislauf(-anschluss) eine Drucküberwachung mit Datenaufnahme installiert ist. Diese müsste allerdings autark über mehrere Jahrzehnte laufen und würde lediglich für den Beweisfall für eine Schadensregulierung die Daten speichern und zu einer Schadensbegrenzung aufgrund der kurzen Druckpulse kaum oder ungenügend beitragen. Solche Systeme sind zudem auch teuer und brauchen Platz und sind über die auf Jahrzehnte ausgelegte Einsatzdauer hinaus unzuverlässig.

Um das gefundene Problem und die genannten Nachteile zu lösen, wird seitens der Erfindung eine Lösung angegeben, die vorsieht, dass im Kühlsystem durch beim Einfüllen der Kühlflüssigkeit willkürlich eingeschlossene Luft der schädlichen Wirkung auftretender Druckpulsation begegnen wird.

Die Figur 2 zeigt in einem zweiten Diagramm B einen zur Verifikation dieser Lösung mittels für eine Kühlkreislaufsimulation geeigneten Test erzeugten Verlauf eines Druckpulses wie er in einem die erfindungsgemäße Wirkweise verwirklichenden Kühlkreislaufsystem auftreten kann.

Anhand des in Figur 2 gezeigten zweiten Diagramms B ist ein Ausführungsbeispiel des erfindungsgemäßen Verfahrens zu erkennen. Gemäß dieses Ausführungsbeispiels des erfindungsgemäßen Verfahrens wird ein Lufteinschluss während der Befüllung des Kreislaufs durch mindestens ein mit dem Kühlmittelbehältnis verbundenen Mittel zum Lufteinschluss bewirkt, das derart ausgeformt und mit dem Kühlmittelbehältnis verbunden wird, dass die eingeschlossene Luft den Kühlmittelstrom nicht unterbricht.

Es wird also so verfahren, dass bewirkt wird, dass Luft im Kühlkreislauf des Umrichters an bestimmten Stellen während der Befüllung des Kreises quasi festgehalten wird.

Hierdurch wird, da Luft kompressibel ist, ein Luftpolster erzeugt, das die Druckpulsationen deutlich mindern kann, da die Energie des Druckpulses primär an die Luftpolster als nachgiebigstes Element im Kreislauf abgegeben wird.

Das einem Druckpulsationsteststand entstammende zweite Diagramm B bezieht sich zwar auf ein Testumfeld, welches betrieben wird, um Wärmetauscher und Kühlplatten zu qualifizieren. Doch dies genügt, um die Wirkung des Ausführungsbeispiels nachzustellen. Dabei wurde in diesem Testumfeld zur Erzeugung des ersten Diagramms A ein Druck beispielsweise von ca. 2bar auf ca. 14bar schlagartig erhöht, kurzgehalten und dann schlagartig reduziert.

Um die Funktionalität des erfindungsgemäßen Ausführungsbeispiels des Verfahrens darzustellen, wurde in einem zweiten Testlauf das System zuvor nicht perfekt entlüftet. Somit wies es Lufteinschlüsse, also erfindungsgemäße Luftpolster, auf.

Im zweiten Diagramm B kann man erkennen, dass ein schlagartiges Erhöhen oder Reduzieren des Druckes nicht mehr möglich war. Der maximal auftretende Druck erreicht zwar in beiden Figuren Figur 1 und Figur 2 ca. 14bar, weil bei der Realisierung des Experiments in diesem Testumfeld, das eine andere Zielsetzung hat, erst mit dem Erreichen eines Drucks dieser Höhe die Drucksteigerung des Testsystems beendet wird, so dass beim zweiten Diagramm B irgendwann, wenn die Wirkung des Lufteinschlusses aufgehoben ist, der Druck schlagartig auf die 14bar hochschnellt. Der Verlauf des Drucks im System bis zu diesem Zeitpunkt zeigt aber deutlich den unterschiedlichen Verlauf des Systems mit und ohne Lufteinschlüsse. Dies gilt sowohl für die Zeit eines Druckauf- und -abbaus sowie auch bezüglich der Steilheit der Kurven.

Aus diesen Unterschieden lässt sich erkennen, dass die Lufteinschlüsse einem Druckimpuls lange standhalten und auch einen weit geringeren Maximaldruck entstehen lassen. Die Kompressionsfähigkeit der Luft nimmt einen beachtlichen Teil der Energie des Druckpulses weg.

Die Figur 3 zeigt nun schematisch den Aufbau eines Umrichters UR gemäß Stand der Technik, welcher für den Anschluss eines Kühlsystems vorbereitet ist.

Ein hierzu passendes Kühlsystem KS zeigt die Figur 4. Figur 4 zeigt dies ebenfalls schematisch. Zu erkennen ist der Aufbau des für den Umrichter UR vorgesehenen Kühlsystems gemäß dem Stand der Technik. Dieses Kühlsystem KS weist erkennbar drei Hauptrohre HR1...HR3 auf.

Die Figur 5 zeigt nun schematisch ein Ausführungsbeispiel der erfindungsgemäßen Vorrichtung BP welche einem Ausführungsbeispiel des erfindungsgemäßen Verfahrens folgend das Kühlsystem KS vor den Auswirkungen von Druckpulsen schützt.

Hierzu ist die Vorrichtung als ein Rohr ausgestaltet, das am Hauptrohrmaximalpunkt HR3_TOP in der Art eines Bypasses BP von einem Teil des dritten Hauptrohres HR3 abgeführt und nach einem kurzen, gemäß gewünschter Einschlussmenge von Luft dimensionierten, Abstand wieder dem dritten Hauptrohr H3 zugeführt wird, wobei Zu- und Abfuhr offen mit dem dritten Hauptrohr H3 verbunden sind, so dass die Luft und gegebenenfalls etwas Kühlmittel in den Bypass BP eindringt, wie in der Figur 5 anhand des zur Betrachtung vergrößerten Ausschnitts des Bypasses BP gezeigt wird.

Dabei ist die Erfindung nicht auf dieses Ausführungsbeispiel beschränkt. Es können beispielsweise mehrere solcher Bypass BP Vorrichtungen angebracht sein. An einem Rohr und/oder über alle Hauptrohre HR1 ...HR3 verteilt. Auch sind unterschiedliche Ausformungen der erfindungsgemäßen Vorrichtung BP möglich, die aufgrund ihrer Form besser geeignet sind die Luftpolster aufzufangen. Auch kann die Form und die Platzierung eines Hauptrohres zu einer angepassten Ausgestaltung eines Bypasses BP führen, so dass innerhalb eines Kühlsystems unterschiedliche Formen auftreten können und/oder zu unterschiedlichen Kühlsystemen unterschiedliche Formen ausgebildet werden. Diesbezüglich ist die Erfindung flexibel, solange die Vorrichtungen BP die erfindungsgemäße Funktion ermöglichen, dass während des Befüllens die Luft nicht etwa, beispielsweise über eine Entlüftung, entweicht, sondern in der jeweiligen erfindungsgemäßen Vorrichtung BP hängen bleibt.

Im vorliegenden Ausführungsbeispiel wird dies beispielsweise dadurch bewirkt, dass die Vorrichtung BP an der zum Zeitpunkt des Befüllens höchsten Stelle des dritten Hauptrohres HR3 platziert ist. Dann nämlich ist erfindungsgemäßes Festhalten der Luft dadurch gesichert, dass diese automatisch zum höchsten Punkt des Systems steigt und dort verbleibt, wenn der Kühlstrom unter der Luft fließen kann.

Damit ist eine sehr einfache, zuverlässige, kostensparende und auch über den ganzen Zeitraum gleichbleibende Lösung zur Minimierung der schädlichen Wirkung von Druckpulsationen gewährleistet.

In anderen Worten seien unter Nennung weiterer Vorteile weitere Details und Ausgestaltungsmöglichkeiten genannt.

Wie dargestellt wurde, wird der Luftpolstereffekt dadurch erzielt, dass dem Hauptkühlkreis an der höchsten Stelle ein Bypass eingebaut wird, dabei überwindet die Erfindung den Widerstand gegen Lufteinschlüsse im System, denn normalerweise versucht man einen Kühlkreislauf blasenfrei zu befüllen. Dies ist auch weiterhin notwendig, um die Funktion der Pumpen nicht negativ zu beeinträchtigen. Gemäß der Erfindung wird aber während des Befüllvorgangs absichtlich die Luft in dem Bypass eingeschlossen und so ein blasenfreier Kühlmittelstrom trotz eines Lufteinschlusses erreicht. Das Hauptrohr bleibt damit weiterhin blasenfrei befüllt, denn die Vorrichtung ist gewissermaßen ein Nebenrohr. Dadurch ist es gewährleistet, dass keine Luft in die Pumpe kommt und trotzdem Luft im Kühlkreislauf vorhanden ist, so dass hierdurch wiederum die erfindungsgemäß eingesetzte Wirkung der Kompressibilität der Luft zur Druckpulsationsminimierung genutzt werden kann, wobei die Stärke des Effekts durch die eingeschlossene Luftmenge gesteuert werden kann.

Die Erfindung stellt eine sehr kosteneffiziente Lösung für das Problem dar. Kein Gerät des Kühlkreislaufs muss überdimensioniert werden, was Kosten und Gewicht spart. Die Kosten für die Lösung an sich, sind im Grunde vernachlässigbar gering. Bei dem gezeigten Ausführungsbeispiel benötigt die Vorrichtung BP lediglich, insbesondere als Winkeladapter ausgeformte, Eckrohrstücke an jeweils einer Stelle des dritten Hauptrohres HR3 und ein kurzes Stück Rohr, das an seinen Enden an diese Stücke beispielsweise durch Schweißen oder Schrauben angeschlossen ist. Denkbar sind auch (Spritz-)Gussausführungen, die an das Hauptrohrstück angebracht werden oder sogar mit diesem als Einheit gefertigt werden.

Unabhängig vom grammatikalischen Geschlecht eines bestimmten Begriffes sind Personen mit männlicher, weiblicher oder anderer Geschlechteridentität mit umfasst.

## Patentansprüche

**1.** Anordnung zur Kühlung einer Vorrichtung, insbesondere elektrischen Vorrichtung, wie beispielsweise einen, vorzugsweise für den Einsatz im industriellen Umfeld betriebenen, Umrichter, aufweisend zumindest einen, insbesondere als Rohr ausgebildeten, ersten Hohlkörper zur Aufnahme einer Kühlflüssigkeit der Kühlungsanordnung, derart ausgestaltet, dass auf dem höchsten Punkt des ersten Hohlkörpers ein zweiter Hohlkörper derart ausgeformt und mit dem ersten Hohlkörper derart verbunden ist, dass beim Befüllen des ersten Hohlkörpers mit der Kühlflüssigkeit, zumindest ein Teil des zweiten Hohlkörpers ein Gas, insbesondere Raumluft, derart einschließt, dass nach dem Befüllen das Gas in der Anordnung zur Kühlung, vorzugsweise im zweiten Hohlkörper, erhalten bleibt, wobei Gas und Kühlmittel zumindest nach dem Befüllen derart mechanisch aufeinander einwirken können, dass eine Ausdehnung der Kühlflüssigkeit das im zweiten Hohlkörper konservierte Gas komprimieren kann.

**2.** Anordnung nach dem vorhergehenden Anspruch,
**dadurch gekennzeichnet, dass** die Verbindung zwischen erstem Hohlkörper und zweitem Hohlkörper derart ausgestaltet ist, dass das Gas durch eine zumindest temporär, insbesondere während des Befüllens, verschlossene Trennvorrichtung von der Kühlflüssigkeit getrennt ist.

**3.** Anordnung nach dem vorhergehenden Anspruch,
**dadurch gekennzeichnet, dass** die Trennvorrichtung derart ausgestaltet ist, dass sie manuell und/oder motorgetrieben, insbesondere prozessorgesteuert, verschließbar ist.

**3.** Anordnung nach dem Anspruch 2,
**dadurch gekennzeichnet, dass** die Trennvorrichtung derart ausgestaltet ist, dass sie dauerhaft verschlossen ist, wobei die Trennvorrichtung zumindest teilweise als flexible Membran ausgestaltet ist.

**4.** Anordnung nach dem Anspruch 1,
**dadurch gekennzeichnet, dass** die Verbindung zwischen erstem Hohlkörper und zweitem Hohlkörper derart ausgestaltet ist, dass zumindest ein Teil des zweiten Hohlkörpers für die Kühlflüssigkeit derart durchlässig ist, dass die Kühlflüssigkeit jederzeit unmittelbaren Kontakt zum eingeschlossenen Gas hat.

**5.** Anordnung nach einem der vorhergehenden Ansprüche,
**dadurch gekennzeichnet, dass** der zweite Hohlkörper am ersten Hohlkörper derart ausgeformt ist, dass zumindest Teile des zweiten Hohlkörpers ab dem Befüllen und während des Betriebs der Kühlung über dem höchsten Niveau des Kühlmittels in der Kühlungsanordnung dauerhaft zu liegen kommen.

**6.** Anordnung nach einem der vorhergehenden Ansprüche,
**dadurch gekennzeichnet, dass** die Verbindung zwischen zweitem Holkörper und erstem Hohlkörper derart ausgestaltet ist, dass der zweite Hohlkörper mit dem ersten Hohlkörper zumindest teilweise durch Verschweißungen verbunden ist.

**7.** Anordnung nach einem der Ansprüche 1 bis 5,
**dadurch gekennzeichnet, dass** die Verbindung zwischen zweitem Holkörper und erstem Hohlkörper derart ausgestaltet ist, dass erster Hohlkörper und zweiter Hohlkörper eine, insbesondere durch ein Gießverfahren erzeugte, Einheit bilden.

**8.** Anordnung nach einem der Ansprüche 1 bis 5,
**dadurch gekennzeichnet, dass** die Verbindung zwischen zweitem Holkörper und erstem Hohlkörper derart ausgestaltet ist, dass der zweite Hohlkörper durch Schrauben am ersten Hohlkörper befestigt wird.

**9.** Anordnung nach einem der vorhergehenden Ansprüche,
**dadurch gekennzeichnet, dass** der zweite Hohlkörper, als eine aus zumindest einem rohrförmigen Teil gebildete Anordnung ausgestaltet ist.

**10.** Anordnung nach dem vorhergehenden Anspruch,
**dadurch gekennzeichnet, dass** der zweite Hohlkörper als Rohr ausgestaltet ist, wobei das derart ausgeformt und mit dem ersten Hohlkörper verbunden ist, dass zumindest ein Rohrende des Rohres mit dem zweiten Hohlkörper für die Kühlflüssigkeit durchlässig verbunden ist und aus dem ersten Hohlkörper heraustritt.

**11.** Anordnung nach dem Anspruch 9 oder 10,
**dadurch gekennzeichnet, dass** das zweite Rohrende des Rohres und/oder rohrförmigen Teils verschlossen ist.

**12.** Anordnung nach dem Anspruch 10,
**dadurch gekennzeichnet, dass** das Rohr seitlich in den ersten Hohlkörper wieder eintritt und durchlässig mit ihm verbunden ist.

**13.** Anordnung nach dem Anspruch 9,
**dadurch gekennzeichnet, dass** der zweite Hohlkörper aus einem Rohrstück sowie einem ersten und einem zweiten, jeweils an einem Ende des Rohrstücks befestigten, Winkelstück gebildet ist, wobei jeweils das freie Ende des Winkelstücks mit dem ersten Hohlkörper für die Kühlflüssigkeit durchlässig verbunden ist und wobei das Rohrstück parallel zum ersten Hohlkörper verläuft.

**14.** Verfahren zur Kühlung einer Vorrichtung, insbesondere elektrischen Vorrichtung, wie einem beispielsweise einem, vorzugsweise für den Einsatz im industriellen Umfeld betriebenen, Umrichter, mit zumindest einem, insbesondere als Rohr ausgebildeten, ersten Hohlkörper zur Aufnahme einer Kühlflüssigkeit der Kühlungsanordnung derart, dass auf dem höchsten Punkt des ersten Hohlkörpers ein zweiter Hohlkörper derart ausgeformt und mit dem ersten Hohlkörper derart funktional verbunden und betrieben wird, dass beim Befüllen des ersten Hohlkörpers mit der Kühlflüssigkeit, zumindest in einem Teil des zweiten Hohlkörpers ein Gas, insbesondere Raumluft, derart eingeschlossen wird, dass nach dem Befüllen das Gas in der Anordnung zur Kühlung, vorzugsweise im zweiten Hohlkörper, erhalten bleibt, wobei Gas und Kühlmittel zumindest nach dem Befüllen derart mechanisch aufeinander einwirken können, dass eine Ausdehnung der Kühlflüssigkeit das im zweiten Hohlkörper konservierte Gas komprimieren kann.
